# EUROPEAN PATENT APPLICATION

(11) **EP 2 528 085 A1**
(43) Date of publication of application: **28.11.2012**
(21) Application number: 10843836.7
(22) Date of filing: 02.12.2010
(51) Int. Cl.: H01L 21/02, H01L 21/336, H01L 27/00, H01L 27/12, H01L 29/786

(54) **SEMICONDUCTOR DEVICE AND MANUFACTURING METHOD THEREOF**

(30) Priority: 22.01.2010 JP 2010012122
(71) Applicant: Sharp Kabushiki Kaisha, Osaka-shi, Osaka 545-8522 (JP)
(72) Inventor: TOMIYASU, Kazuhide, Osaka 545-8522 (JP); TAKAFUJI, Yutaka, Osaka 545-8522 (JP); FUKUSHIMA, Yasumori, Osaka 545-8522 (JP); TADA, Kenshi, Osaka 545-8522 (JP); MATSUMOTO, Shin, Osaka 545-8522 (JP)
(74) Representative: Müller - Hoffmann & Partner
(86) International application number: PCT/JP2010/007031
(87) International publication number: WO 2011/089670

(57) **Abstract**

A semiconductor device (130) includes: a bonding substrate (100); a thin film element (80) formed on the bonding substrate (100); and a semiconductor element (90) bonded to the bonding substrate (100), the semiconductor element (90) including semiconductor element main body (50) and a plurality of underlying layers (51-54) stacked on a side of the semiconductor element main body (50) facing the bonding substrate (100), and each of the underlying layers (51-54) including an insulating layer and a circuit pattern on the insulating layer, wherein an end of the semiconductor element (90) facing the thin film element (80) is provided in a stepped form so that the closer to the bonding substrate the underlying layers are, the farther ends of the underlying layers facing the thin film element protrude, the end of the semiconductor element (90) is covered with a resin layer (120), and the thin film element (80) is connected to the semiconductor element main body (50) via a connection line (121a) provided on the resin layer (120).

## Description

### TECHNICAL FIELD

The present invention relates to semiconductor devices and to methods for fabricating the same, and specifically to a semiconductor device including a semiconductor element bonded to a substrate provided with a thin film element and to a method for fabricating the same.

### BACKGROUND ART

Liquid crystal display devices using an active matrix driving scheme include, for example, thin film elements such as thin film transistors (hereinafter also referred to as "TFTs") each provided as a switching element for every pixel which is a minimum unit of an image, and semiconductor elements such as drive circuits for driving the TFT for every pixel.

In recent years, in liquid crystal display devices, for example, a system liquid crystal in which peripheral circuits such as drive circuits are monolithically formed by using continuous grain silicon has drawn attention. In the system liquid crystal, in order to reduce power consumption or increase resolution, a design rule of the order of submicron, that is, high patterning accuracy at an integrated circuit (IC) level is required for the peripheral circuits. However, there is no manufacturing technique such as a stepper corresponding to a used glass substrate, and thus it is difficult to form high-performance semiconductor elements of the order of submicron directly on the glass substrate. For this reason, a method has been proposed in which after forming high-performance semiconductor elements by using a silicon substrate, chips of the formed semiconductor elements are transferred and bonded to a glass substrate, thereby forming the high-performance semiconductor elements on the glass substrate.

For example, Patent Document 1 describes a method for fabricating a semiconductor device, the method including: transferring a semiconductor element onto a substrate, the semiconductor element having a multilayer structure of a silicon layer and a metal layer, and by heating, forming metal silicide from silicon for a metal layer-side part of the silicon layer and metal for a silicon layer-side part of the metal layer.

### CITATION LIST

### PATENT DOCUMENT

PATENT DOCUMENT 1: International Patent Publication No. WO 2008/084628

### SUMMARY OF THE INVENTION

### TECHNICAL PROBLEM

In a conventional semiconductor device in which semiconductor elements such as IC chips are transferred to a glass substrate having thin film elements such as TFTs formed thereon, a multilayer interconnect structure is used in many cases in order to reduce an area occupied by circuit patterns integrated into the semiconductor elements to reduce electrical resistance of the circuit patterns, wherein the multilayer interconnect structure is formed in such a manner that the plurality of circuit patterns in the semiconductor elements are formed to overlap each other with an insulating film interposed therebetween, and the circuit patterns are connected to each other via a contact hole formed in the insulating film. Here, since the semiconductor elements are formed by dicing the silicon substrate, walls of the semiconductor elements are orthogonal to a surface of the glass substrate, which is also referred to as a bonding substrate. Thus, there is a large difference in height between the thin film elements formed on the glass substrate and the semiconductor elements bonded to the glass substrate and having a multilayer interconnect structure. Thus, when the thin film elements and the semiconductor elements on the glass substrate are covered with a resin layer, connection lines are formed on the resin layer, and the thin film elements and the semiconductor elements are connected via the connection lines, the connection lines may be broken due to the large difference in height between the thin film elements and the semiconductor elements having the multilayer interconnect structure.

In view of the foregoing, the present invention was devised. It is an objective of the present invention to ensure connection between thin film elements provided on a bonding substrate and semiconductor elements having a multilayer interconnect structure provided on a bonding substrate.

### SOLUTION TO THE PROBLEM

To achieve the objective, in the present invention, an end of a semiconductor element facing a thin film element is formed in a stepped shape, and is covered with a resin layer, and the thin film element and the semiconductor element main body are connected to each other via a connection line provided on the resin layer.

Specifically, a semiconductor device according to the present invention includes: a bonding substrate; a thin film element formed on the bonding substrate; and a semiconductor element bonded to the bonding substrate, the semiconductor element including a semiconductor element main body and a plurality of underlying layers stacked on a side of the semiconductor element main body facing the bonding substrate, each of the underlying layers including an insulating layer and a circuit pattern on the insulating layer, and the circuit patterns being connected to each other via contact holes formed in the insulating layers, wherein an end of the semiconductor element facing the thin film element is provided in a stepped form so that the closer to the bonding substrate the underlying layers are, the farther ends of the underlying layers facing the thin film element protrude, the end of the semiconductor element is covered with a resin layer, and the thin film element is connected to the semiconductor element main body via a connection line provided on the resin layer.

With this configuration, an end of the semiconductor element facing the thin film element is provided in a stepped form so that the closer to the bonding substrate the underlying layers are, the farther the ends of the underlying layers facing the thin film element protrude, where the underlying layers are stacked on a side of the semiconductor element main body facing the bonding substrate, and the semiconductor element is bonded to the bonding substrate. Thus, although there is a large difference in height between the thin film element and the semiconductor element having the multilayer interconnect structure, overall inclination of a wall of the semiconductor element facing the thin film element is gentle compared to the case, for example, where walls of the semiconductor element are orthogonal to the bonding substrate. Moreover, since the overall gently inclined wall of the semiconductor element facing the thin film element, that is, the end of the semiconductor element facing the thin film element is covered with a resin layer, a surface of the resin layer is flat compared to the case, for example, where the walls of the semiconductor element are orthogonal to the bonding substrate. Thus, even when there is a large difference in height between the thin film element and the semiconductor element having the multilayer interconnect structure, the connection line provided on the resin layer is less likely to be broken. Therefore, connection of the thin film element to the semiconductor element main body via the connection line can be ensured, and thus it is possible to ensure connection of the thin film element provided on the bonding substrate to the semiconductor element having the multilayer interconnect structure.

The bonding substrate may be a glass substrate.

With this configuration, the bonding substrate is a glass substrate. Thus, for example, in an active matrix substrate made of glass included in a liquid crystal display device, a semiconductor device is specifically formed.

The thin film element may be a thin film transistor, and the semiconductor element main body may be a MOS transistor.

With this configuration, the thin film element is a thin film transistor, and the semiconductor element main body is a metal oxide semiconductor (MOS) transistor. Thus, for example, on an active matrix substrate made of glass included in a liquid crystal display device, the thin film element specifically forms a switching element, a gate driver, or the like for every pixel, and the semiconductor element main body specifically forms an IC of a source driver, a controller, or the like.

A method for fabricating a semiconductor device according to the present invention includes: a semiconductor chip forming step of forming a semiconductor element main body, and then in forming a plurality of underlying layers, forming metal layers having a predetermined size to form a semiconductor chip, where each of the underlying layers includes an insulating layer and a circuit pattern on the insulating layer, the circuit patterns are connected to each other via contact holes formed in the insulating layers, and each of the metal layer is formed at an outer end of the underlying layer and at a same layer as the circuit pattern in the underlying layer, and is made of a same material as the circuit pattern; a thin film element forming step of forming a thin film element on the bonding substrate; a bonding step of bonding the semiconductor chip onto the bonding substrate provided with the thin film element with the semiconductor element main body facing upward; an etching step of etching the metal layer at the outer end of each of the underlying layer of the semiconductor chip bonded to the bonding substrate to process an end of the semiconductor chip facing the thin film element into a stepped form so that the closer to the bonding substrate the underlying layers are, the farther ends of the underlying layers facing the thin film element protrude; and a connecting step of covering an end of the semiconductor element facing the thin film element with a resin layer, and then forming a connection line on the resin layer to connect the thin film element to the semiconductor element main body.

With this method, the semiconductor element is formed in such a manner that in the etching step, the metal layer at an outer end of each of the underlying layers of the semiconductor chip bonded to the bonding surface is etched to process an end of the semiconductor chip facing the thin film element into a stepped form so that the closer to the bonding substrate the underlying layers are, the farther the ends of the underlying layers facing the thin film element protrude, where the underlying layers are stacked on a side of the semiconductor element main body facing the bonding substrate, and the semiconductor chip is bonded to the bonding substrate. Thus, although there is a large difference in height between the thin film element and the semiconductor element having the multilayer interconnect structure, overall inclination of a wall of the semiconductor element facing the thin film element is gentle compared to the case, for example, where walls of the semiconductor element are orthogonal to the bonding substrate. Moreover, since the overall gently inclined wall of the semiconductor element facing the thin film element, that is, the end of the semiconductor element facing the thin film element is covered with a resin layer in the connecting step, a surface of the resin layer is flat compared to the case, for example, where the walls of the semiconductor element are orthogonal to the bonding substrate. Thus, even when there is a large difference in height between the thin film element and the semiconductor element having the multilayer interconnect structure, the connection line formed on the resin layer in the connection step is less likely to be broken. Therefore, connection of the thin film element to the semiconductor element main body via the connection line can be ensured, and thus it is possible to ensure connection of the thin film element provided on the bonding substrate to the semiconductor element having the multilayer interconnect structure.

### ADVANTAGES OF THE INVENTION

According to the present invention, the end of the semiconductor element facing the thin film element is provided in a stepped form, and is covered with a resin layer, and the thin film element and the semiconductor element main body are connected to each other via a connection line provided on the resin layer, so that it is possible to ensure connection of the thin film element provided on the bonding substrate to the semiconductor element having the multilayer interconnect structure.

### BRIEF DESCRIPTION OF THE DRAWINGS

[FIG. 1] FIG. 1 is a cross-sectional view illustrating a semiconductor device according to an embodiment of the present invention.
[FIG. 2] FIGS. 2A-2D are first cross-sectional views illustrating steps for fabricating the semiconductor device according to the embodiment of the present invention.
[FIG. 3] FIGS. 3A-3C are second cross-sectional views illustrating the semiconductor device in steps following the step of FIG. 2D.
[FIG. 4] FIGS. 4A-4C are third cross-sectional views illustrating the semiconductor device in steps following the step of FIG. 3C.
[FIG. 5] FIGS. 5A-5C are fourth cross-sectional views illustrating the semiconductor device in steps following the step of FIG. 4C.
[FIG. 6] FIGS. 6A-6C are fifth cross-sectional views illustrating the semiconductor device in steps following the step of FIG. 5C.
[FIG. 7] FIGS. 7A-7C are sixth cross-sectional views illustrating the semiconductor device in steps following the step of FIG. 6C.
[FIG. 8] FIGS. 8A-8C are seventh cross-sectional views illustrating the semiconductor device in steps following the step of FIG. 7C.
[FIG. 9] FIG. 9 is an eighth cross-sectional view illustrating the semiconductor device in a step following the step of FIG. 8C.
[FIG. 10] FIG. 10 is a ninth cross-sectional view illustrating the semiconductor device in a step following the step of FIG. 9.
[FIG. 11] FIG. 11 is a tenth cross-sectional view illustrating the semiconductor device in a step following the step of FIG. 10.
[FIG. 12] FIG. 12 is an eleventh cross-sectional view illustrating the semiconductor device in a step following the step of FIG. 11.
[FIG. 13] FIG. 13 is a twelfth cross-sectional view illustrating the semiconductor device in a step following the step of FIG. 12.
[FIG. 14] FIG. 14 is a thirteenth cross-sectional view illustrating the semiconductor device in a step following the step of FIG. 13.
[FIG. 15] FIG. 15 is a fourteenth cross-sectional view illustrating the semiconductor device in a step following the step of FIG. 14.
[ 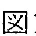 16] FIG. 16 is a fifteenth cross-sectional view illustrating the semiconductor device in a step following the step of FIG. 15.
[FIG. 17] FIG. 17 is a plan view illustrating a step of fabricating an intermediate substrate used in the steps of fabricating the semiconductor device according to the embodiment of the present invention.
[FIG. 18] FIG. 18 is a cross-sectional view taken along the line XVIII-XVIII of FIG. 17.
[FIG. 19] FIG. 19 is a plan view illustrating the intermediate substrate in a step following the step of FIG. 17.
[FIG. 20] FIG. 20 is a cross-sectional view taken along the line XX-XX of FIG. 19.

### DESCRIPTION OF EMBODIMENTS

Embodiments of the present invention will be described in detail below with reference to the drawings. The present invention is not limited to the following embodiments.

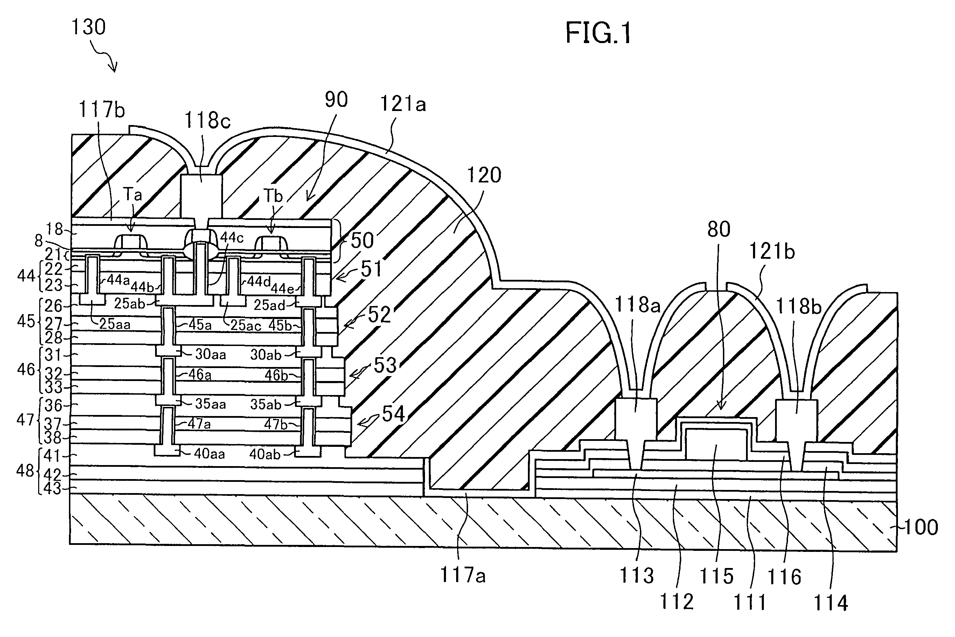

FIGS. 1-20 are views illustrating an embodiment of a semiconductor device and a method for fabricating the same according to the present invention. Specifically, FIG. 1 is a cross-sectional view illustrating a semiconductor device 130 of the present embodiment.

As illustrated in FIG. 1, the semiconductor device 130 includes a glass substrate 100 provided as a bonding substrate, a thin film element 80 formed on the glass substrate 100, a semiconductor element 90 bonded to the glass substrate 100, a resin layer 120 provided to cover the thin film element 80 and the semiconductor element 90, a first connection line 121a a for connecting (the below-described source electrode 118a of) the thin film element 80 to (the below-described connection electrode 118c of) the semiconductor element 90, and a second connection line 121 b for being connected to (the below-described drain electrode 118b of) the thin film element 80, where the first connection line 121a and the second connection line 121 b are provided on the resin layer 120.

As illustrated in 1, the thin film element 80 includes a semiconductor layer 113 provided on the glass substrate 100 with a first base coat film 111 and a second base coat film 112 being interposed between the semiconductor layer 113 and the glass substrate 100, a gate insulating film 114 provided to cover the semiconductor layer 113, a gate electrode 115 provided on the gate insulating film 114, a first interlayer insulating film 116, and a second interlayer insulating film 117a, where the first interlayer insulating film 116 and the second interlayer insulating film 117a are sequentially provided to cover the gate electrode 115. Here, the semiconductor layer 113 includes a channel region (not shown) provided to overlap the gate electrode 115, a source region (not shown) provided on one outer side of the channel region, and a drain region (not shown) provided on the other outer side of the channel region. The semiconductor layer 113 is made of a polysilicon film. Note that the semiconductor layer 113 may have lightly doped drain (LDD) regions respectively provided between the channel region and the source region and between the channel region and the drain region. As illustrated in FIG. 1, the source electrode 118a and the drain electrode 118b respectively connected to the source region and the drain region of the semiconductor layer 113 are provided on the second interlayer insulating film 117a via contact holes formed in a multilayer film composed of the gate insulating film 114, the first interlayer insulating film 116, and the second interlayer insulating film 117a.

As illustrated in FIG. 1, the semiconductor element 90 includes a semiconductor element main body 50, and a first underlying layer 51, a second underlying layer 52, a third underlying layer 53, a fourth underlying layer 54, and a fifth insulating layer 48 which are formed in this order on a surface of the semiconductor element main body 50 facing the glass substrate 100. An end of the semiconductor element 90 facing the thin film element 80 is provided in a stepped form so that the closer to the glass substrate 100 the underlying layers 51, 52, 53, and 54 are, the farther ends of the underlying layers 51, 52, 53, and 54 facing the thin film element 80 protrude. Here, the thickness of each of the underlying layers 51, 52, 53, and 54 is, for example, about 0.5 µm. The ends of the lower underlying layers (52, 53, and 54) protrude from the ends of their respective upper underlying layers (51, 52, and 53) by, for example, about 1 µm.

As illustrated in FIG. 1, the semiconductor element main body 50 includes an n-type NMOS transistor Ta provided in a left region of a monocrystalline silicon film 21 in the figure, a p-type PMOS transistor Tb provided in a right region of the monocrystalline silicon film 21 in the figure, a gate oxide film 8 for isolating the NMOS transistor Ta from the PMOS transistor Tb, and a planarizing film 18 provided to cover the NMOS transistor Ta and the PMOS transistor Tb. Note that since it is difficult to describe the configuration of the semiconductor element main body 50 with reference to FIG. 1 in which the semiconductor element main body 50 is illustrated in a relatively small size, the configuration of the semiconductor element main body 50 will be described in detail with reference to a drawing in which the semiconductor element main body 50 is illustrated in a relatively large size in describing a semiconductor chip forming step in the below-described method for fabricating the semiconductor device 130.

As illustrated in FIG. 1, the first underlying layer 51 includes a first insulating layer 44 composed of a first interlayer insulating film 22 and a second interlayer insulating film 23, and first circuit patterns 25aa, 25ab, 25ac, and 25ad stacked on the first insulating layer 44. Here, as illustrated in FIG. 1, the first circuit pattern 25aa is connected to one of n-type high-concentration impurity regions of the monocrystalline silicon film 21 of the NMOS transistor Ta via a first contact hole 44a formed in the first insulating layer 44. Moreover, as illustrated in FIG. 1, the first circuit pattern 25ab is connected to the other of the n-type high-concentration impurity regions of the monocrystalline silicon film 21 of the NMOS transistor Ta via a first contact hole 44b formed in the first insulating layer 44. The first circuit pattern 25ab is also connected to the connection electrode 118c via a first contact hole 44c, or the like formed in the first insulating layer 44 and the gate oxide film 8. Furthermore, as illustrated in FIG. 1, the first circuit pattern 25ac is connected to one of p-type high-concentration impurity regions of the monocrystalline silicon film 21 of the PMOS transistor Tb via a first contact hole 44d formed in the first insulating layer 44, and the first circuit pattern 25ad is connected to the other of the p-type high-concentration impurity regions of the monocrystalline silicon film 21 of the PMOS transistor Tb via a first contact hole 44e formed in the first insulating layer 44.

As illustrated in FIG. 1, the second underlying layer 52 includes a second insulating layer 45 composed of a first planarizing film 26, a first interlayer insulating film 27, and a second interlayer insulating film 28, and second circuit patterns 30aa and 30ab stacked on the second insulating layer 45. Here, as illustrated in FIG. 1, the second circuit pattern 30aa is connected to the first circuit pattern 25ab via a second contact hole 45a formed in the second insulating layer 45, and the second circuit pattern 30ab is connected to the first circuit pattern 25ad via a second contact hole 45b formed in the second insulating layer 45.

As illustrated in FIG. 1, the third underlying layer 53 includes a third insulating layer 46 composed of a second planarizing film 31, a first interlayer insulating film 32, and a second interlayer insulating film 33, and third circuit patterns 35aa and 35ab stacked on the third insulating layer 46. Here, as illustrated in FIG. 1, the third circuit pattern 35aa is connected to the second circuit pattern 30aa via a third contact hole 46a formed in the third insulating layer 46, and the third circuit pattern 35ab is connected to the second circuit pattern 30ab via a third contact hole 46b formed in the third insulating layer 46.

As illustrated in FIG. 1, the fourth underlying layer 54 includes a fourth insulating layer 47 composed of a third planarizing film 36, a first interlayer insulating film 37, and a second interlayer insulating film 38, and fourth circuit patterns 40aa and 40ab stacked on the fourth insulating layer 47. Here, as illustrated in FIG. 1, the fourth circuit pattern 40aa is connected to the third circuit pattern 35aa via a fourth contact hole 47a formed in the fourth insulating layer 47, and the fourth circuit pattern 40ab is connected to the third circuit pattern 35ab via a fourth contact hole 47b formed in the fourth insulating layer 47.

As illustrated in FIG. 1, the fifth insulating layer 48 is composed of a fourth planarizing film 41, a first interlayer insulating film 42, and a second interlayer insulating film 43.

The semiconductor device 130 having the above-described configuration is included in a liquid crystal display device, wherein, for example, the thin film element 80 forms, for example, a switching element of a pixel which is a minimum unit of an image, a gate driver, etc., and the semiconductor element main body 50 forms, for example, a source driver, an IC of a controller, etc.

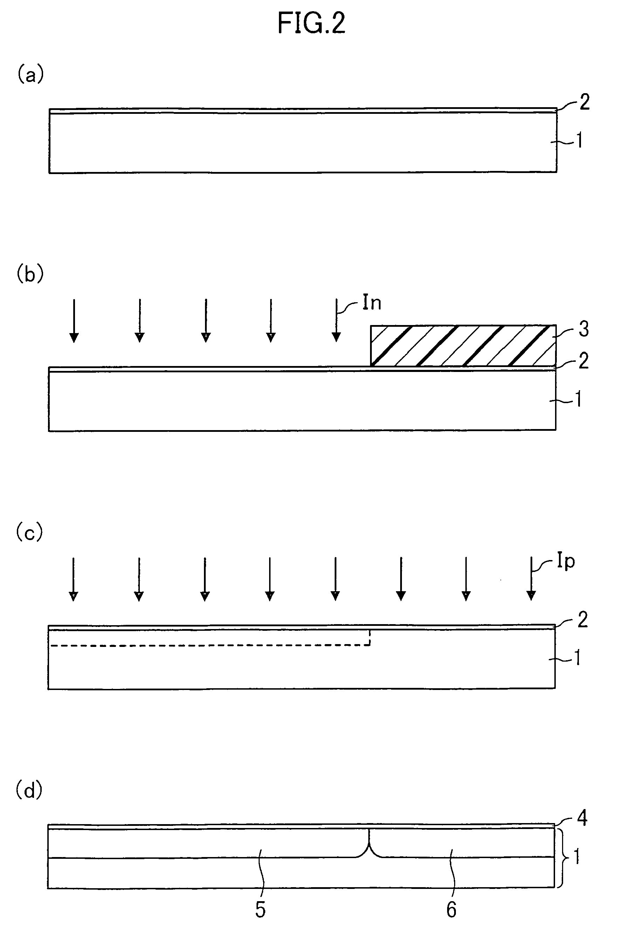

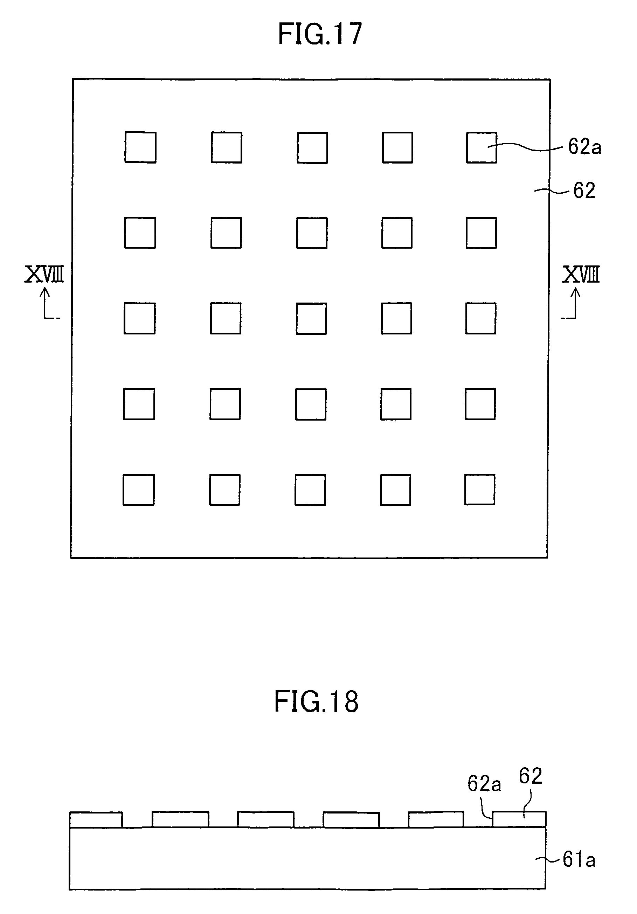

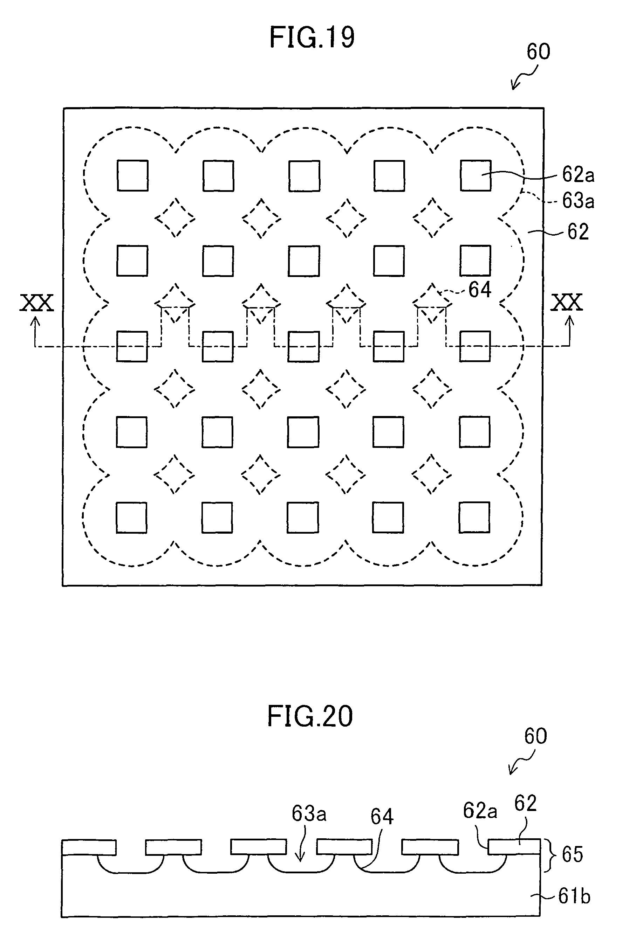

Next, a method for fabricating the semiconductor device 130 of the present embodiment will be described with reference an example in FIGS. 2-20. Here, FIGS. 2-16 are a series of cross-sectional views illustrating fabrication steps of the semiconductor device 130. Moreover, FIG. 17 is a plan view illustrating a fabrication process of an intermediate substrate 60 used in the fabrication steps of the semiconductor device 130. FIG. 18 is a cross-sectional view taken along the line XVIII-XVIII of FIG. 17. Moreover, FIG. 19 is a plan view illustrating a fabrication step of the intermediate substrate 60 following the step of FIG. 17. FIG. 20 is a cross-sectional view taken along the line XX-XX of FIG. 19. Note that the fabrication method of the present embodiment includes a semiconductor chip forming step, a thin film element forming step, a bonding step, an etching step, and a connecting step.

### <Semiconductor Chip Forming Step>

First, as illustrated in FIG. 2A, a thermal oxide film 2 having a thickness of, for example, about 30 nm is formed on a silicon substrate (monocrystalline silicon substrate) 1. Here, the thermal oxide film 2 is formed for the purpose of protecting a surface of the silicon substrate 1 from being contaminated in later-performed ion implantation, and is not necessarily essential. Thus, the thermal oxide film 2 may be omitted.

Subsequently, as illustrated in FIG. 2B, a resist 3 is formed on the thermal oxide film 2. Then, using the resist 3 as a mask, an n-type impurity element In (e.g., phosphorus) is injected into an N well formation region which is an opening region of the resist 3 by, for example, ion implantation. Here, the ion implantation is preferably performed under conditions where the implantation energy is set to about 50 keV-150 keV, and the dose amount is about 1 × 10¹² cm⁻²-1 × 10¹³ cm⁻². Moreover, since a p-type impurity element is injected into an entire surface of the silicon substrate 1 in a later step, the injection amount of the n-type impurity element is preferably set in consideration of an amount balanced with the p-type impurity element.

Then, as illustrated in FIG. 2C, the resist 3 is removed. After that, the p-type impurity element Ip (e.g., boron) is implanted into the entire surface of the silicon substrate 1 by, for example, ion implantation. Here, the ion implantation is preferably performed under conditions where the implantation energy is about 10 keV-50 keV, and the dose amount is about 1 × 10¹² cm⁻²-1 × 10¹³ cm⁻². Moreover, since phosphorus has a lower diffusion coefficient in silicon in terms of thermal treatment than boron, a thermal treatment may be performed before a boron element is implanted so that the phosphorus is moderately diffused into the silicon substrate in advance. Alternatively, to avoid cancellation of n-type impurities by p-type impurities in the N well formation region, the p-type impurity element may be injected after a resist is formed on the N well formation region. In this case, the cancellation by the p-type impurities does not need to be taken into consideration in injecting the n-type impurities into the N well formation region.

Then, as illustrated in FIG. 2D, the thermal oxide film 2 is removed. After that, a thermal treatment in an oxidizing atmosphere at about 900°C-1000°C is performed, thereby forming a thermal oxide film 4 having a thickness of about 30 nm, and diffusing the impurity elements to form an N well region 5 and a P well region 6.

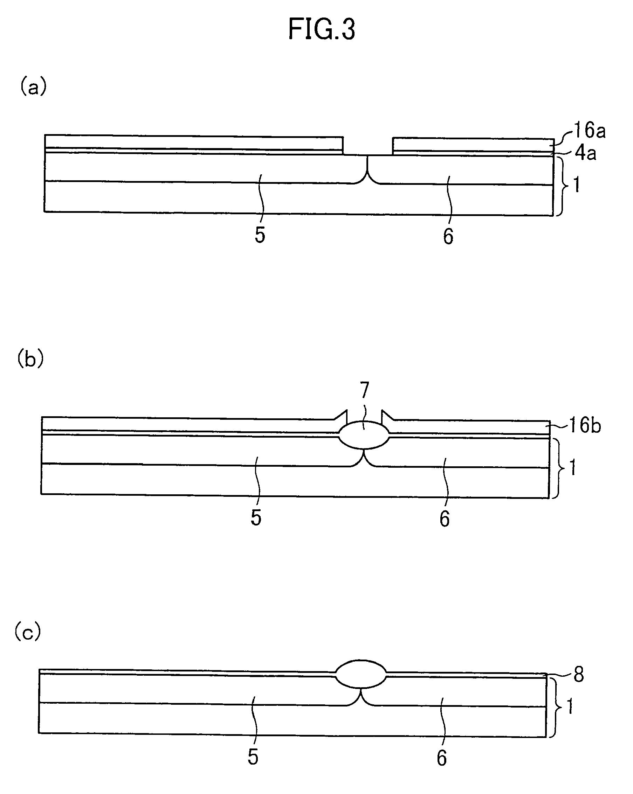

Subsequently, on the entirety of the substrate in which the N well region 5 and the P well region 6 has been formed, a silicon nitride film having a thickness of about 200 nm is formed by, for example, chemical vapor deposition (CVD), or the like. Then, the silicon nitride film and the thermal oxide film 4 under the silicon nitride film are patterned by using photolithography, or the like, thereby forming a silicon nitride film 16a and a thermal oxide film 4a as illustrated in FIG. 3A.

After that, as illustrated in FIG. 3B, a local oxidation of silicon (LOCOS) process is performed by a thermal treatment in an oxygen atmosphere at about 900°C-1000°C, thereby forming a LOCOS oxide film 7 having a thickness of about 200 nm-500 nm, and a silicon nitride film 16b. Here, the LOCOS oxide film 7 is used for device isolation, but the device isolation may be achieved by, for example, shallow trench isolation (STI), or the like other than the LOCOS oxide film 7.

Then, as illustrated in FIG. 3C, the silicon nitride film 16b is removed. After that, a thermal treatment in an oxygen atmosphere at about 1000°C is performed, thereby forming a gate oxide film 8 having a thickness of about 10 nm-20 nm from the LOCOS oxide film 7. Here, after the removal of the silicon nitride film 16b, in order to control the threshold voltage of a transistor, n-type impurities or p-type impurities may be implanted by ion implantation in a region in which an NMOS transistor Ta or a PMOS transistor Tb will be formed.

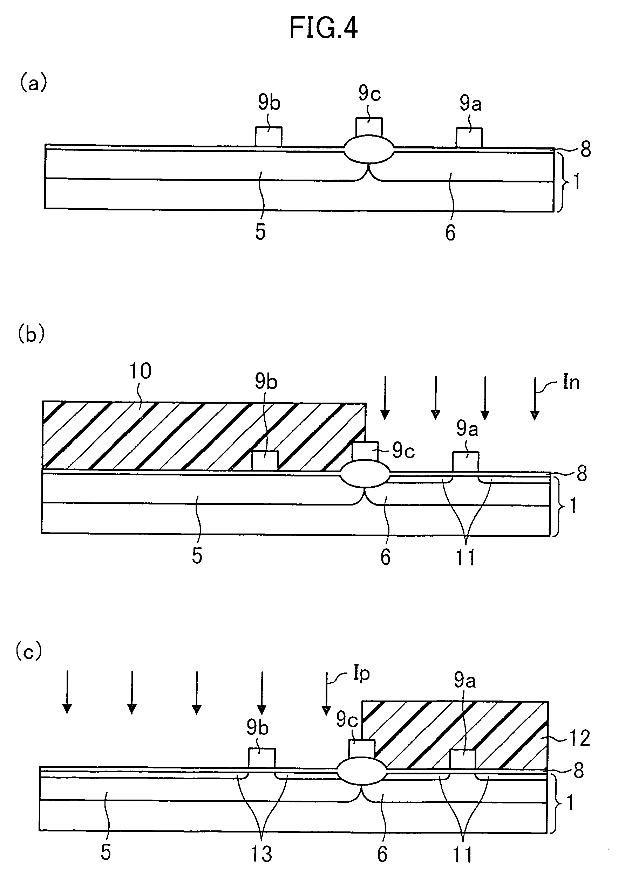

Subsequently, as illustrated in FIG. 4A, on the entirety of the substrate provided with the gate oxide film 8, a polysilicon film having a thickness of about 300 nm is deposited by, for example, CVD, or the like. Then, the polysilicon film is patterned by using photolithography, or the like, thereby forming a gate electrode 9a of the NMOS transistor Ta, a gate electrode 9b of the PMOS transistor Tb, and a relay electrode 9c.

Then, as illustrated in FIG. 4B, in order to form a LDD region, a resist 10 is formed with an NMOS transistor formation region being open. After that, by using the gate electrode 9a as a mask, an n-type impurity element In (e.g., phosphorus) is implanted by, for example, ion implantation, thereby forming an n-type low-concentration impurity region 11. Here, the ion implantation is preferably performed under conditions where the dose amount is, for example, about 5 × 10¹² cm⁻²-5 × 10¹³ cm⁻². Here, the impurity concentration of the n-type low-concentration impurity region 11 is, for example, 1 × 10¹⁷/cm³-5 × 10¹⁷/cm³. Moreover, here, in order to reduce the short channel effect, halo implantation of a p-type impurity element such as boron may be performed.

Then, as illustrated in FIG. 4C, the resist 10 is removed, and a resist 12 is formed with a PMOS transistor formation region being open. Thereafter, by using the gate electrode 9b as a mask, a p-type impurity element Ip (e.g., boron) is implanted by, for example, ion implantation, thereby forming a p-type low-concentration impurity region 13. Here, the ion implantation is preferably performed under conditions where the dose amount is, for example, about 5 × 10¹² cm⁻²-5 × 10¹³ cm⁻². Here, the impurity concentration of the p-type low-concentration impurity region 13 is, for example, 1 × 10¹⁷/cm³-5 × 10¹⁷/cm³. Moreover, here, in order to reduce a short channel effect, halo implantation of an n-type impurity element such as phosphorus may be performed. Note that boron has a large thermal diffusion coefficient, and thus when a PMOS low-concentration impurity region can be formed only by thermal diffusion of boron implanted by p-type high-concentration impurity implantation into a PMOS transistor in a later step, impurity implantation for forming the p-type low-concentration impurity region is not necessarily performed.

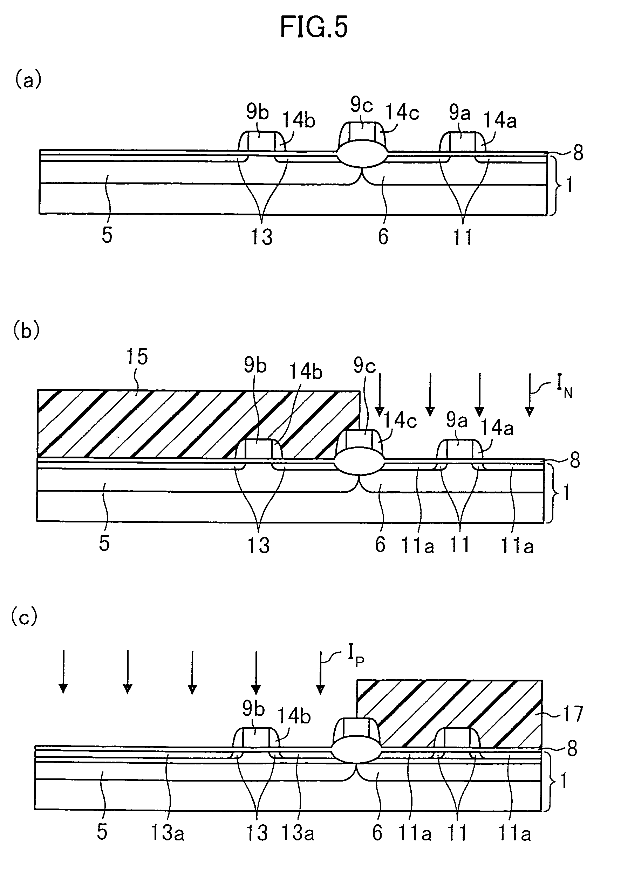

Subsequently, as illustrated in FIG. 5A, the resist 12 is removed. Then, a silicon oxide film is formed by, for example, CVD, or the like. Thereafter, the silicon oxide film is anisotropically dry etched, thereby forming sidewalls 14a, 14b, and 14c on walls of the gate electrodes 9a, 9b, and the relay electrode 9c.

Then, as illustrated in FIG. 5B, a resist 15 is formed with the NMOS transistor formation region being open, and by using the gate electrode 9a and the sidewalls 14a as a mask, an n-type impurity element In (e.g., phosphorus) is implanted by, for example, ion implantation, thereby forming an n-type high-concentration impurity region 11a. Here, the impurity concentration of the n-type high-concentration impurity region 11a is, for example, 1 × 10¹⁹/cm³-1 × 10²¹/cm³.

Then, as illustrated in FIG. 5C, the resist 15 is removed, and a resist 17 is formed with the PMOS transistor formation region being open. Then, by using the gate electrode 9b and the sidewalls 14b as a mask, a p-type impurity element Ip (e.g., boron) is implanted by, for example, ion implantation, thereby forming a p-type high-concentration impurity region 13a. Here, the impurity concentration of the p-type high-concentration impurity region 13a is, for example, 1 × 10¹⁹/cm³-5 × 10²⁰/cm³. Thereafter, for example, a thermal treatment at 900°C for 10 minutes is performed to activate the implanted impurity elements, thereby forming the NMOS transistor Ta and the PMOS transistor Tb.

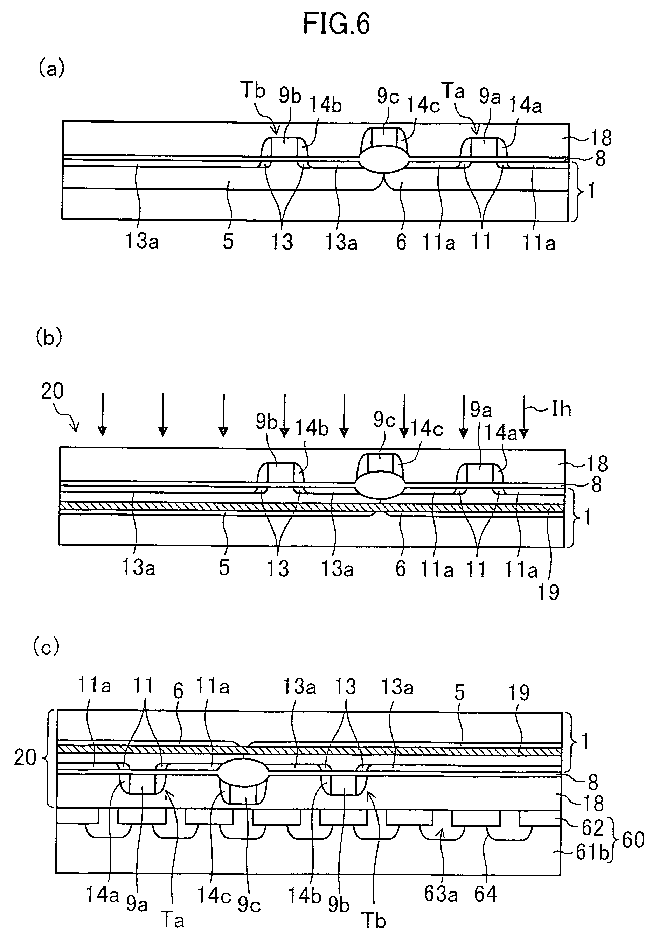

Subsequently, the resist 17 is removed. Then, an insulating film such as a silicon oxide film is formed over the entirety of the substrate provided with the NMOS transistor Ta and the PMOS transistor Tb. The insulating film is planarized by chemical mechanical polishing (CMP), or the like, thereby forming a planarizing film 18 as illustrated in FIG. 6A.

Then, as illustrated in FIG. 6B, a release substance Ih containing at least one inactive element such as hydrogen, He, or Ne is implanted into the silicon substrate 1 by, for example, ion implantation, thereby forming a release layer 19 to form a semiconductor substrate 20. Here, the release substance is implanted under conditions where for example, when hydrogen is used, the dose amount is 2 x 10¹⁶ cm ²-2 × 10¹⁷ cm⁻², and the implantation energy is about 100 keV-200 keV.

Then, a bonding surface of the semiconductor substrate 20 provided with the release layer 19 and a bonding surface of an intermediate substrate 60 are hydrophilized by ammonia-hydrogen peroxide-based SC1 cleaning. After that, the bonding surface of the semiconductor substrate 20 is laid on the bonding surface of the intermediate substrate 60, and a thermal treatment at, for example, 200°C-300°C for about 2 hours is performed, thereby bonding the semiconductor substrate 20 to the intermediate substrate 60 as illustrated in FIG. 6C. Here, as illustrated in FIGS. 6C, 19, and 20, the intermediate substrate 60 includes a thermal oxidation layer 62 in which a plurality of openings 62a are formed in a matrix pattern, and a silicon substrate 61b provided under the thermal oxidation layer 62, wherein a plurality of recessed sections 63a respectively in communication with the openings 62a in the thermal oxidation layer 62 are formed in the silicon substrate 61b. Moreover, as illustrated in 20, the intermediate substrate 60 is provided with a separating structure 65 which includes the above-described thermal oxidation layer 62 and columnar silicon structures 64 supporting the thermal oxidation layer 62 at a plurality of positions, and can separate between the silicon substrate 61b and the thermal oxidation layer 62. The intermediate substrate 60 can be fabricated in the following manner. First, a silicon substrate 61 a is thermally oxidized to form a thermal oxide film having a thickness of about 100-300 nm. Then, the thermal oxide film is patterned by using photolithography, or the like to form square openings, for example, about 0.5 µm on a side as illustrated in FIGS. 17 and 18, thereby forming the thermal oxidation layer 62 having the plurality of openings 62a with an opening pitch of about 1.5 µm. Subsequently, an upper portion of the silicon substrate 61a is etched by gas such as xenon difluoride via the openings 62a, thereby forming the recessed sections 63a as illustrated in FIG. 19 and FIG. 20. Note that the silicon substrate 61a may be etched by an alkaline solution such as tetramethyl ammonium hydroxide (TMAH). Moreover, suitably setting the diameter and the height of the columnar silicon structures 64 allows the design of the intermediate substrate 60 which withstands a later-performed CMP step, and is separable by torsional stress.

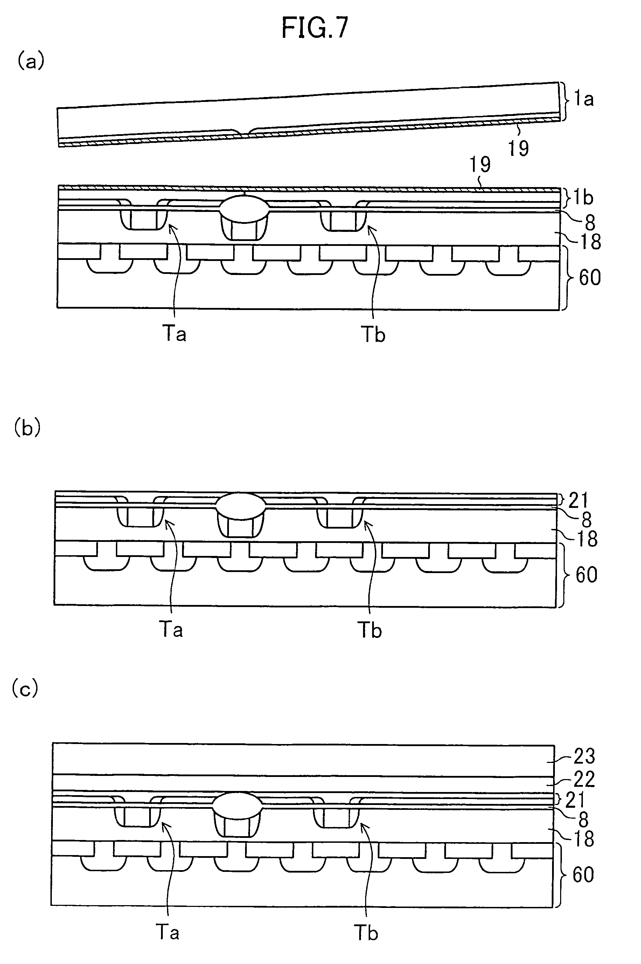

Subsequently, the temperature of the semiconductor substrate 20 and the intermediate substrate 60 bonded to each other is raised to about 550°C-600°C to separate the silicon substrate 1 along the release layer 19 into silicon substrates 1a and 1b as illustrated in FIG. 7A, so that the NMOS transistor Ta and the PMOS transistor Tb are once transferred onto the intermediate substrate 60.

Then, as illustrated in FIG. 7B, the release layer 19 is removed by polishing (the above-mentioned CMP step), etching, or the like. After that, the silicon substrate 1b is polished or etched until the gate oxide film 8 is exposed, thereby forming a monocrystalline silicon film 21 and performing a device isolation process.

Thereafter, as illustrated in FIG. 7C, a first interlayer insulating film 22 such as a silicon oxide film is formed to have a thickness of about 100 nm in order to protect a surface of the monocrystalline silicon film 21. Then, a thermal treatment is performed at about 650°C-800°C for about 30 minutes to 2 hours to remove hydrogen in the monocrystalline silicon film 21, completely remove thermal donors and lattice defects, reactivate the p-type impurities, improve the reproducibility of transistor characteristics, and stabilize the transistor characteristics. Moreover, in order to retain sufficient capacitance between interconnects without influencing the transistor characteristics, a second interlayer insulating film 23 such as a silicon oxide film is formed to have a thickness of about 700 nm. Note that the temperature in the thermal treatment is preferably 850°C or lower so that the impurity profiles of the transistors do not degrade.

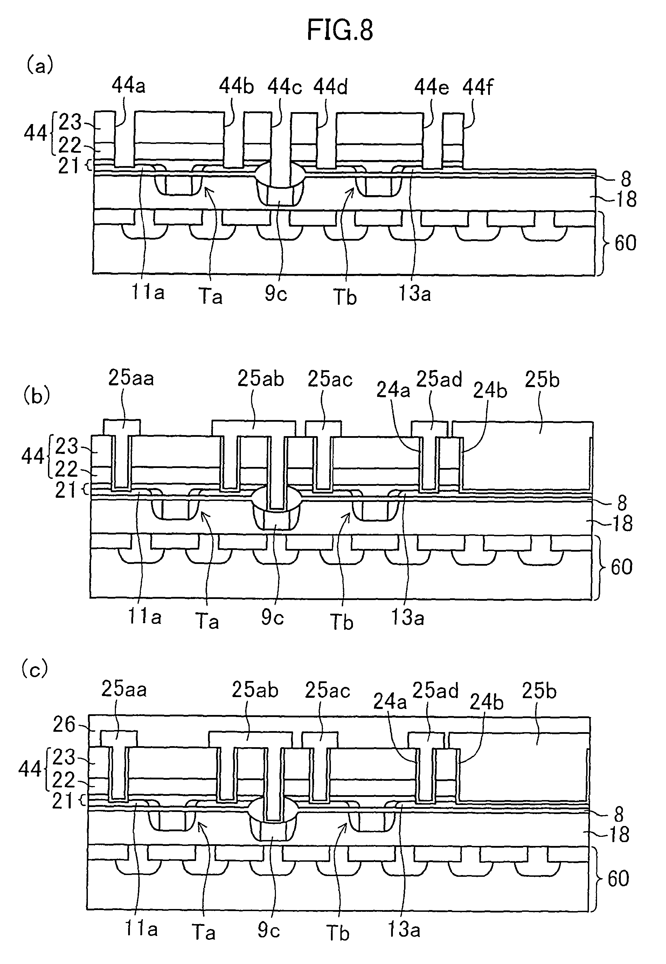

Subsequently, as illustrated in FIG. 8A, the monocrystalline silicon film 21, the first interlayer insulating film 22, and the second interlayer insulating film 23 are partially etched, thereby forming first contact holes 44a and 44b which reach the n-type high-concentration impurity region 11 a forming a source region and a drain region of the NMOS transistor Ta, first contact holes 44d and 44e which reach the p-type high-concentration impurity region 13a forming a source region and a drain region of the PMOS transistor Tb, and a first opening 44f in which an end of the p-type high-concentration impurity region 13 of the PMOS transistor Tb is exposed. The gate oxide film 8, the first interlayer insulating film 22, and the second interlayer insulating film 23 are partially etched, thereby forming a first contact hole 44c which reaches the relay electrode 9c.

Then, a metal film having low resistance is formed on the entirety of the substrate provided with the first contact holes 44a-44e and the first opening 44f. After that, the metal film is patterned by photolithography, or the like, thereby forming first circuit patterns 25aa-25ad and a first metal layer 25b as illustrated in FIG. 8B. Here, the first circuit patterns 25aa-25ad and the first metal layer 25b are formed, for example, in such a manner that a titanium film and a titanium nitride film, for example, which will be a barrier metal layers 24a and 24b are sequentially formed, an Al-Cu alloy film, for example, is formed as a metal film having low resistance, and then a multilayer film composed of the titanium film, the titanium nitride film, and the Al-Cu alloy film is patterned. Moreover, since the impurity concentrations of the n-type high-concentration impurity region 11a and the p-type high-concentration impurity region 13a are 1 × 10¹⁹/cm³-1 × 10²¹/cm³ and 1 × 10¹⁹/cm³. 1 × 10²⁰/cm³, respectively, it is possible to ensure low-resistance connection of the first circuit patterns 25aa-25ad to the monocrystalline silicon film 21. Moreover, when the first contact holes 44a, 44b, 44d, and 44e are formed, it is preferable that a surface of the monocrystalline silicon film be exposed under etching conditions where the selectivity ratio for the oxide films and the silicon film is high, and then the monocrystalline silicon film be further etched in consideration of the thickness of the silicon film to the high-concentration impurity regions. Note that in the present embodiment, to remove hydrogen in the monocrystalline silicon film 21, and to remove thermal donors and lattice defects, a thermal treatment has been performed, and thus even when a metal material such as Al-Si, Al-Cu, Cu, etc. is used as the circuit patterns, diffusion of the metal material can be reduced.

Then, on the entirety of the substrate provided with the first circuit patterns 25aa-25ad and the first metal layer 25b, a silicon oxide film is formed by plasma enhanced (PE) CVD, or the like using mixed gas of tetraethoxysilane (TEOS) and oxygen. Thereafter, the silicon oxide film is planarized by CMP, or the like, thereby forming a first planarizing film 26 as illustrated in FIG. 8C.

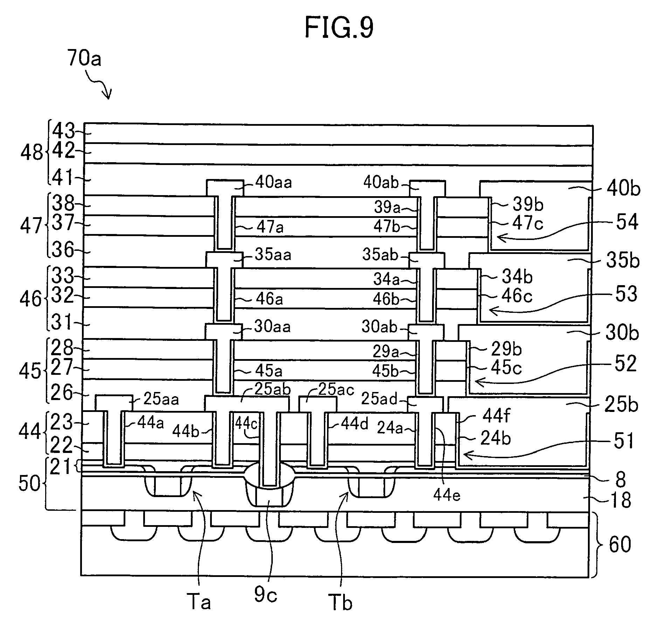

Finally, the above-described steps of forming the first interlayer insulating film, the second interlayer insulating film, the contact holes, the circuit patterns, the metal layer, and the planarizing film are repeated to sequentially form, as illustrated in FIG. 9, a first interlayer insulating film 27, a second interlayer insulating film 28, second contact holes 45a and 45b, a second opening 45c, barrier metal layers 29a and 29b, second circuit patterns 30aa and 30ab, a second metal layer 30b, a second planarizing film 31, a first interlayer insulating film 32, a second interlayer insulating film 33, third contact holes 46a and 46b, a third opening 46c, barrier metal layers 34a and 34b, third circuit patterns 35aa and 35ab, a third metal layer 35b, a third planarizing film 36, a first interlayer insulating film 37, a second interlayer insulating film 38, fourth contact holes 47a and 47b, a fourth opening 47c, barrier metal layers 39a and 39b, fourth circuit patterns 40aa and 40ab, a fourth metal layer 40b, a fourth planarizing film 41, a first interlayer insulating film 42, and a second interlayer insulating film 43. Then the intermediate substrate 60 is cut to a predetermined size.

In the above-described manner, it is possible to form a semiconductor chip 70a in which a semiconductor element main body 50, a first underlying layer 51 whose outer end is provided with the first metal layer 25b, a second underlying layer 52 whose outer end is provided with the second metal layer 30b, a third underlying layer 53 whose outer end is provided with the third metal layer 35b, a fourth underlying layer 54 whose outer end is provided with the fourth metal layer 40b, and a fifth insulating layer 48 are sequentially stacked on the intermediate substrate 60.

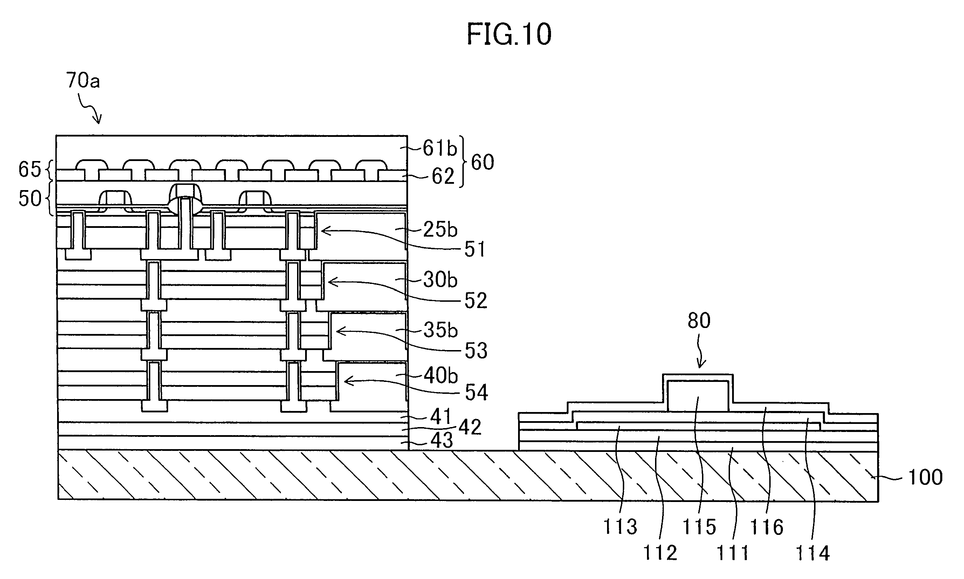

### <Thin Film Element Forming Step (see FIG. 10, etc.)>

First, a silicon oxide film (having a thickness of about 100 nm) and a silicon nitride film (having a thickness of about 100 nm) are sequentially formed by PECVD, or the like on the entirety of a glass substrate 100. Then, a multilayer film composed of the silicon oxide film and the silicon nitride film is patterned by using photolithography, or the like, thereby forming a first base coat film 111 and a second base coat film 112, respectively.

Sequentially, on the entirety of the substrate provided with the first base coat film 111 and the second base coat film 112, an amorphous silicon film (having a thickness of about 50 nm) is formed by PECVD, or the like, and the amorphous silicon film is transformed by a heating treatment into a polysilicon film. Thereafter, the polysilicon film is patterned by photolithography, or the like, thereby forming a semiconductor layer 113.

Then, on the entirety of the substrate provided with the semiconductor layer 113, a silicon oxide film (having a thickness of about 100 nm) is formed by PECVD, or the like. After that, the silicon oxide film is patterned by photolithography, or the like, thereby forming a gate insulating film 114.

Thereafter, on the entirety of the substrate provided with the gate insulating film 114, a tantalum nitride film (having a thickness of about 50 nm) and a tungsten film (having a thickness of about 350 nm) are sequentially formed by sputtering. After that, a multilayer film composed of the tantalum nitride film and the tungsten film is patterned by photolithography, or the like, thereby forming a gate electrode 115.

Then, using the gate electrode 115 as a mask, for example, phosphorus as an impurity element is injected into the semiconductor layer 113 via the gate insulating film 114, thereby forming a channel region (not shown) in a position which overlaps the gate electrode 115, and a source region (not shown) and a drain region (not shown) outside the channel region. Thereafter, a heating treatment is performed to activate the implanted phosphorus, thereby forming an n-channel TFT. Note that the present embodiment has illustrated the method of implanting phosphorus to form the n-channel TFT, but for example, boron may be implanted to form a p-channel TFT.

Finally, on the entirety of the substrate provided with the gate electrode 115, a silicon oxide film (having a thickness of about 50 nm) is formed by PECVD, or the like, and the silicon oxide film is patterned by photolithography, or the like, thereby forming a first interlayer insulating film 116.

A thin film element 80 can thus be formed.

### <Bonding Step>

First, a bonding surface of the semiconductor chip 70a formed in the semiconductor chip forming step and a bonding surface of the glass substrate 100 on which the thin film element 80 is formed in the thin film element forming step are hydrophilized by ammonia-hydrogen peroxide-based SC1 cleaning. Then, the bonding surface of the semiconductor chip 70a is laid on the bonding surface of the glass substrate 100 to bond the semiconductor chip 70a on the glass substrate 100 provided with the thin film element 80 as illustrated in FIG. 10. Here, for preferable bonding, it is preferable to satisfy the condition that the average surface roughness Ra of the bonding surface is equal to or smaller than 0.2 nm-0.3 nm. Note that the average surface roughness Ra can be determined by atomic force microscopy (AFM). Moreover, the bonding surface of the semiconductor chip 70a and the bonding surface of the glass substrate 100 are bonded to each other by Van der Waals forces and hydrogen bonding, and then a thermal treatment is performed at about 400°C-600°C to cause the following reaction to change the above-described bonding to strong bonding between atoms:
-Si-OH (bonding surface of glass substrate 100) + -Si-OH (bonding surface of semiconductor chip 70a (second interlayer insulating film 43)) → -Si-O-Si- + H₂O

Here, when a metal material having low resistance such as aluminum, tungsten, molybdenum, or the like is used as the circuit patterns, the thermal treatment is preferably performed at a lower temperature. Note that the present embodiment has described the glass substrate as a bonding substrate, but a metal substrate which is made of, for example, stainless steel, and whose surface is covered with a material having insulating properties (silicon oxide film, silicon nitride film, etc.) may be used instead of the glass substrate. Such a substrate has high resistance to shock, and for example, is suitable for organic electro luminescence (EL) display devices, or the like, because such display devices do not require the transparency of the substrate. Alternatively, a plastic substrate whose surface is covered with a silicon oxide film may be used. Such an embodiment is suitable for lightweight display devices. In this case, an intermediate substrate and the plastic substrate may be adhered to each other by an adhesive, or the like.

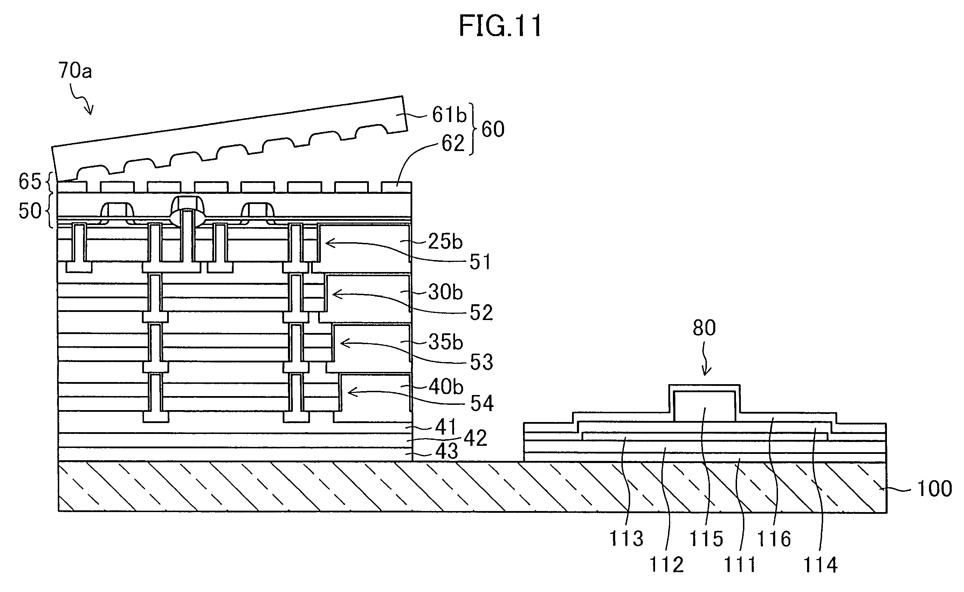

Subsequently, torsional force, sideslip force, peeling force, or the like is applied to the intermediate substrate 60 of the glass substrate 100 bonded to the semiconductor chip 70a, thereby separating the intermediate substrate 60 at the separating structure 65 as illustrated in FIG. 11.

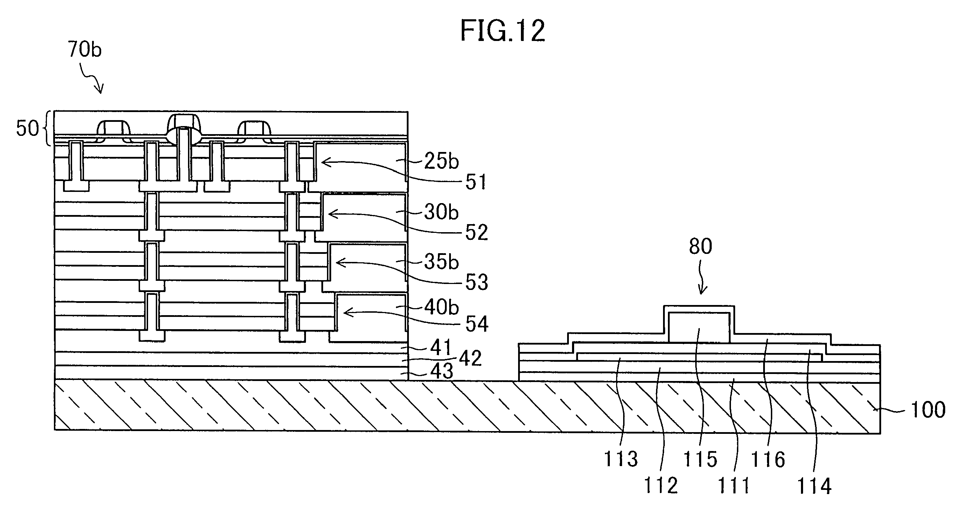

Then, as illustrated in FIG. 12, parts of the columnar portions of the silicon substrate 61 b and the thermal oxidation layer 62 which are remaining on the semiconductor element main body 50 are removed by etching, thereby forming a semiconductor chip 70b.

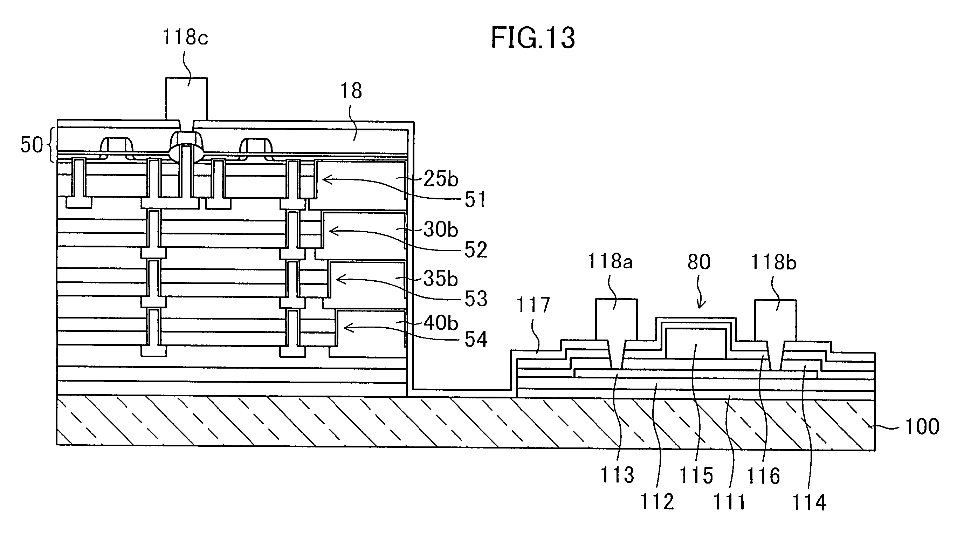

Then, as illustrated in FIG. 13, on the entirety of the substrate provided with the semiconductor chip 70b, a second interlayer insulating film 117 is formed to have a thickness of about 500 nm by CVD, or the like using TEOS and oxygen. Thereafter, contact holes are formed in a multilayer film composed of the gate insulating film 114, the first interlayer insulating film 116, and the second interlayer insulating film 117, and in a multilayer film composed of the planarizing film 18 and the second interlayer insulating film 117. Subsequently, a metal film such as an aluminum film is formed, and then the metal film is patterned by photolithography, or the like, thereby forming a source electrode 118a, a drain electrode 118b, and a connection electrode 118c.

### <Etching Step>

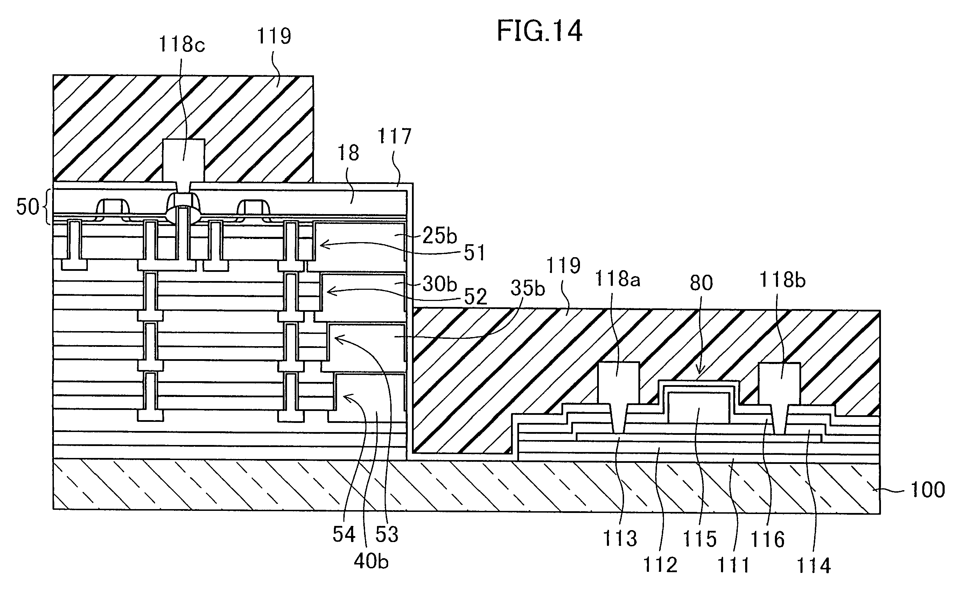

First, as illustrated in FIG. 14, a resist 119 is formed on the glass substrate 100 provided with the source electrode 118a, the drain electrode 118b, and the connection electrode 118c formed in the bonding step.

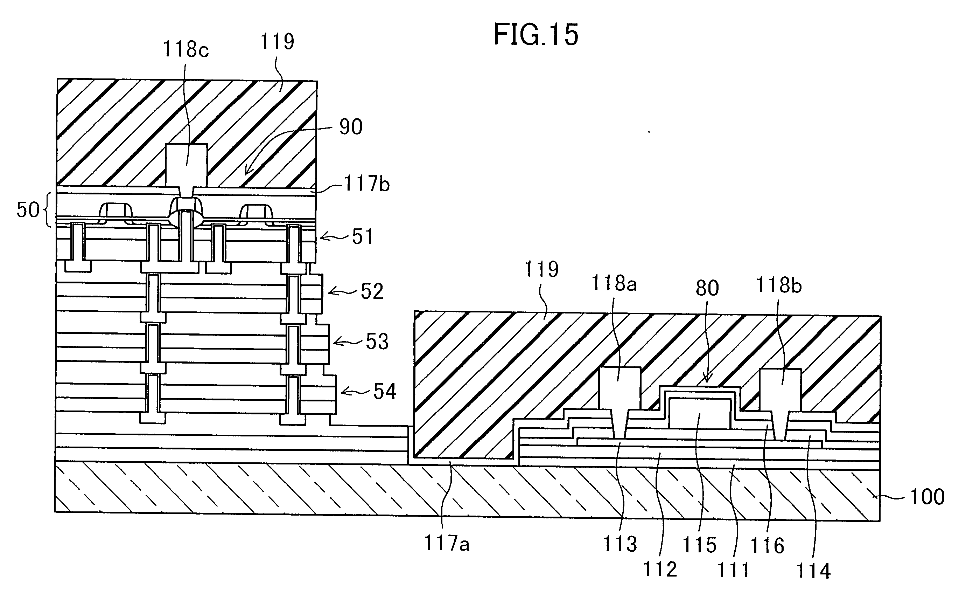

Then, insulating films such as the second interlayer insulating film 117 and the planarizing film 18 exposed form the resist 119 are removed by wet etching. Subsequently, metal films such as the metal layers 25b, 30b, 35b, 40b, the barrier metal layers 24b, 29b, 34b, 39b, and the like are removed by wet etching using an etchant different from that used in wet etching the insulating film to process an end of the semiconductor chip 70b facing the thin film element 80 into a stepped form as illustrated in FIG. 15 so that the closer to the glass substrate 100 the underlying layers 51-54 are, the farther ends of the underlying layers 51-54 facing the thin film element 80 protrude. A semiconductor element 90 is thus formed.

### <Connecting Step>

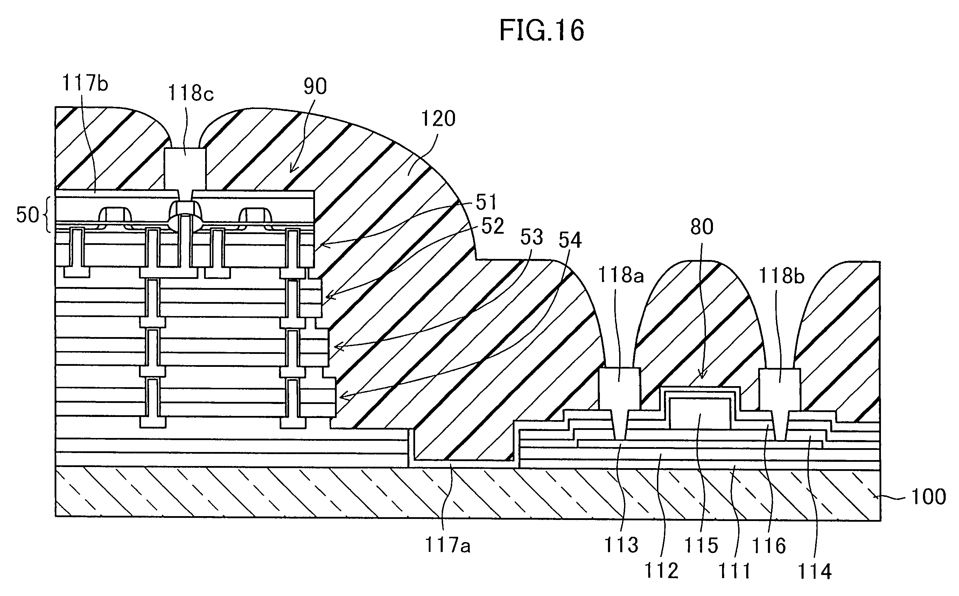

First, the resist 119 used in the etching step is removed. Subsequently, a photosensitive resin film is formed to cover the thin film element 80 and the semiconductor element 90. Then, the photosensitive resin film is exposed, and developed, thereby forming a resin layer 120 covering at least an end of the semiconductor element 90 facing the thin film element 80 as illustrated in FIG. 16.

Then, on the entirety of the substrate provided with the resin layer 120, for example, a transparent conductive film such as an indium tin oxide (ITO) film is formed. Then, the transparent insulating film is patterned by photolithography, or the like, thereby forming a first connection line 121 a and a second connection line 121b as illustrated in FIG. 1 to connect the thin film element 80 to the semiconductor element main body 50.

A semiconductor device 130 is thus fabricated.

As described above, in the semiconductor device 130 and the method for fabricating the same according to the present embodiment, the metal layers 25b, 30b, 35b, and 40b at outer ends of the underlying layers 51-54 of the semiconductor chip 70b bonded to the substrate 100 are etched in the etching step to process an end of the semiconductor chip 70b facing the thin film element 80 into a stepped form so that the closer to the glass substrate 100 the underlying layers 51-54 are, the farther ends of the underlying layers 51-54 facing the thin film element 80 protrude, thereby forming a semiconductor element 90, wherein the semiconductor chip 70b is bonded to the glass substrate 100, and the underlying layers 51-54 are stacked on a side of the semiconductor element main body 50 facing the glass substrate 100. Thus, although there is a large difference in height between the thin film element 80 and the semiconductor element 90 having the multilayer interconnect structure, overall inclination of a wall of the semiconductor element 90 facing the thin film element 80 is gentle compared to the case, for example, where walls of the semiconductor element are orthogonal to the bonding substrate. Moreover, since the overall gently inclined wall of the semiconductor element 90 facing the thin film element 80, that is, the end of the semiconductor element 90 facing the thin film element 80 is covered with a resin layer 120 in the connecting step, a surface of the resin layer 120 is flat compared to the case, for example, where the walls of the semiconductor element are orthogonal to the bonding substrate. Thus, even when there is a large difference in height between the thin film element 80 and the semiconductor element 90 having the multilayer interconnect structure, the first connection line 121 a formed on the resin layer 120 in the connection step is less likely to be broken. Therefore, connection of the thin film element 80 to the semiconductor element main body 50 via the first connection line 121a can be ensured, and thus it is possible to ensure connection of the thin film element 80 provided on the glass substrate 100 to the semiconductor element 90 having the multilayer interconnect structure.

Although the present embodiment has illustrated a TFT as the thin film element 80, a thin film diode (TFD), or the like may be used.

### INDUSTRIAL APPLICABILITY

As described above, the present invention can ensure connection of the thin film element to the semiconductor element having the multilayer interconnect structure. Thus, the present invention is useful for display devices such as liquid crystal display devices, organic EL display devices, or the like.

### DESCRIPTION OF REFERENCE CHARACTERS

- 25aa, 25ab, 25ac, 25ad: First Circuit Pattern
- 25b: First Metal Layer
- 30aa, 30ab: Second Circuit Pattern
- 30b: Second Metal Layer
- 35aa, 35ab: Third Circuit Pattern
- 35b: Second Metal Layer
- 40aa, 40ab: Fourth Circuit Pattern
- 40b: Fourth Metal Layer
- 44: First Insulating Layer
- 44a-44e: First Contact Hole
- 45: Second Insulating Layer
- 45a, 45b: Second Contact Hole
- 46: Third Insulating Layer
- 46a, 46b: Third Contact Hole
- 47: Fourth Insulating Layer
- 47a, 47b: Fourth Contact Hole
- 50: Semiconductor Element Main Body
- 51-54: Underlying Layer
- 70a, 70b: Semiconductor Chip
- 80: Thin Film Element
- 90: Semiconductor Element
- 100: Glass Substrate (Bonding Substrate)
- 120: Resin Layer
- 121 a: First Connection Line
- 130: Semiconductor Device

## Claims

1. A semiconductor device comprising:
a bonding substrate;
a thin film element formed on the bonding substrate; and
a semiconductor element bonded to the bonding substrate, the semiconductor element including a semiconductor element main body and a plurality of underlying layers stacked on a side of the semiconductor element main body facing the bonding substrate, each of the underlying layers including an insulating layer and a circuit pattern on the insulating layer, and the circuit patterns being connected to each other via contact holes formed in the insulating layers, wherein
an end of the semiconductor element facing the thin film element is provided in a stepped form so that the closer to the bonding substrate the underlying layers are, the farther ends of the underlying layers facing the thin film element protrude,
the end of the semiconductor element is covered with a resin layer, and
the thin film element is connected to the semiconductor element main body via a connection line provided on the resin layer.

2. The semiconductor device of claim 1, wherein the bonding substrate is a glass substrate.

3. The semiconductor device of claim 2, wherein
the thin film element is a thin film transistor, and
the semiconductor element main body is a MOS transistor.

4. A method for fabricating a semiconductor device, the method comprising:
a semiconductor chip forming step of forming a semiconductor element main body, and then in forming a plurality of underlying layers, forming metal layers having a predetermined size to form a semiconductor chip, where each of the underlying layers includes an insulating layer and a circuit pattern on the insulating layer, the circuit patterns are connected to each other via contact holes formed in the insulating layers, and each of the metal layer is formed at an outer end of the underlying layer and at a same layer as the circuit pattern in the underlying layer, and is made of a same material as the circuit pattern;
a thin film element forming step of forming a thin film element on the bonding substrate;
a bonding step of bonding the semiconductor chip onto the bonding substrate provided with the thin film element with the semiconductor element main body facing upward;
an etching step of etching the metal layer at the outer end of each of the underlying layer of the semiconductor chip bonded to the bonding substrate to process an end of the semiconductor chip facing the thin film element into a stepped form so that the closer to the bonding substrate the underlying layers are, the farther ends of the underlying layers facing the thin film element protrude; and
a connecting step of covering an end of the semiconductor element facing the thin film element with a resin layer, and then forming a connection line on the resin layer to connect the thin film element to the semiconductor element main body.
